# EUROPÄISCHE PATENTSCHRIFT

(11) **EP 0 934 641 B1**
(45) Veröffentlichungstag und Bekanntmachung des Hinweises auf die Patenterteilung: **02.05.2002**
(21) Anmeldenummer: 97942807.5
(22) Anmeldetag: 05.09.1997
(51) Int. Cl.: H04L 25/02, H03K 5/003

(54) **BIDIREKTIONALE PEGELANPASSUNG FÜR BUSSYSTEME**
BUS SYSTEM BI-DIRECTIONAL LEVEL ADAPTER
ADAPTATION DE NIVEAU BIDIRECTIONNELLE POUR SYSTEMES DE BUS

(30) Priorität: 28.10.1996 DE 19644772
(43) Veröffentlichungstag der Anmeldung: 11.08.1999
(73) Patentinhaber: SIEMENS AKTIENGESELLSCHAFT, 80333 München (DE)
(72) Erfinder: HONSEL, Sigolf, D-81369 München (DE)
(86) Internationale Anmeldenummer: DE9701978
(87) Internationale Veröffentlichungsnummer: WO9819429

(56) Entgegenhaltungen:
- EP-A- 0 004 306
- GB-A- 2 284 954
- US-A- 4 994 690
- US-A- 5 363 405

## Beschreibung

Die Erfindung betrifft eine Schaltung zur bidirektionalen Pegelanpassung.

Integrierte Schaltungen benötigen für den Betrieb Versorgungsspannungen, die manchmal unterschiedlich hohe Pegel aufweisen können. Solche integrierte Schaltungen sind beispielsweise Speicher, Prozessoren und ähnliche Bausteine. Insbesondere Speicherbausteine besitzen bidirektionale Eingabe/Ausgabe-Anschlüsse, an denen diese unterschiedlichen Versorgungsspannungen über die Pull-up Widerstände anliegen. In einem Empfangszustand sind diese Eingabe/Ausgabe-Anschlüsse in einem hochohmigen Zustand. In einem Sendezustand sind diese Anschlüsse in Abhängigkeit vom abgegebenen logischen Zustand in einem hochohmigen oder niederohmigen Zustand.

Werden diese Eingabe/Ausgabe-Anschlüsse zu einem Bussystem zusammengeschaltet, beispielsweise zu einem sogenannten I²C-Bus, so treten bei der Verwendung von unterschiedlich hohen Versorgungsspannungen Probleme auf. Falls der Pull-up Widerstand an die höhere Versorgungsspannung angeschlossen ist, so bewirkt diese einen Strom durch die Schutzdiode des Eingabe/Ausgabe-Anschlusses von dem Baustein, der mit einer niedrigen Spannung betrieben wird. Wird der Pull-up Widerstand dagegen an die niedrige Versorgungsspannung angeschlossen, so kann die mit der höheren Spannung betriebene integrierte Schaltung den logischen "l"-Zustand nicht mehr erkennen.

Zur Lösung dieses Problems ist es bekannt Optokoppler einzusetzen. Durch die hierdurch bewirkte galvanische Entkopplung ist es möglich, die mit unterschiedlichen Versorgungsspannungen betriebenen integrierten Schaltkreise über die Optokoppler zu einem Bussystem zusammenzuschalten.

Der Erfindung liegt die Aufgabe zugrunde, eine kostengünstige Schaltung zur bidirektionalen Pegelanpassung anzugeben.

Diese Aufgabe wird erfindungsgemäß durch die im Patentanspruch 1 oder 2 angegebenen Merkmale gelöst.

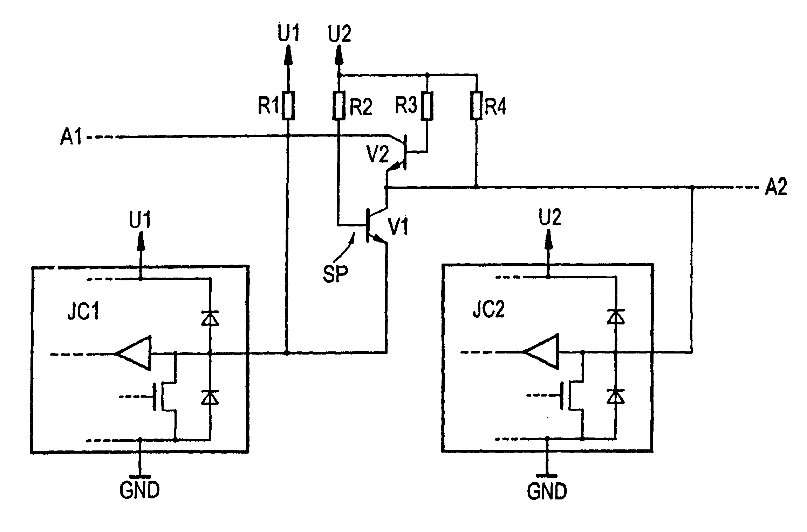

Im folgenden wird die Erfindung anhand eines in der Zeichnung dargestellten Ausführungsbeispieles beschrieben.

In der einzigen Figur sind zwei integrierte Schaltkreise IC1 und IC2 dargestellt. Der integrierte Schaltkreis IC1 ist an einer Spannungsquelle U1, und die integrierte Schaltung IC2 ist an einer Spannungsquelle U2 angeschaltet. Weiter sind beide integrierte Schaltkreise IC1 und IC2 mit einem Bezugspotential GND verbunden. An der Spannungsquelle U1 ist beispielsweise eine Spannung von 5 Volt, und an der Spannungsquelle U2 ist eine Spannung von beispielsweise 3,3 Volt abgreifbar.

Die nicht näher bezeichneten Eingabe/Ausgabe-Anschlüsse der beiden integrierten Schaltkreis IC1 und IC2 sollen beispielsweise über einen I²C-Bus zusammengeschaltet werden.

Hierzu ist erfindungsgemäß eine Schaltung zur Pegelumsetzung SP vorgesehen. Diese Schaltung SP weist einen ersten Anschluß A1 auf, der mit dem integrierten Schaltkreis IC1 verbunden ist, sowie einen Anschluß A2, der mit dem integrierten Schaltkreis IC2 verbunden ist.

Zwischen die beiden Anschlüsse A1 und A2 sind zwei Bipolar-Transistoren V1 und V2 geschaltet. Die Kollektor-Emitter-. Strecken der beiden Transistoren V1 und V2 sind dabei antiparallel zwischen die beiden Anschlüsse A1 und A2 geschaltet. Der Kollektor des Transistors V2 ist mit dem Anschluß A1, der Emitter des Transistors V2 mit dem Anschluß A2, und der Emitter des Transistors V1 ist mit dem Anschluß A1, und der Kollektor des Transistors V1 ist mit dem Anschluß A2 verbunden.

Die Basis- bzw. die Steueranschlüsse der beiden Transistoren V1 und V2 sind jeweils über einen Widerstand R2 bzw R3 mit der Spannungsquelle U2 verbunden, an der die niedrigere Spannung abgreifbar ist.

Der Eingabe/Ausgabe-Anschluß des integrierten Schaltkreises IC1 ist über einen Widerstand R1 mit der Spannungsquelle U1 verbunden. Der Eingabe/Ausgabe-Anschluß der integrierten Schaltkreises IC2 ist über einen Widerstand R4 mit der Spannungsquelle U2 verbunden. Die Widerstände R1 und R4 sind Pull-up Widerstände, die an irgendeiner Stelle der Gesamtschaltung vorgesehen sein können.

Die Steueranschlüsse der beiden Transistoren V1 und V2 sind über die entsprechenden Widerstände R2 und R3 an der Spannungsquelle U2 angeschaltet, da beim Anschluß an die Spannungsquelle U1 mit dem höheren Pegel ein Strom über die Basis-Kollektor-Strecke des Transistors V1 bzw. über die Basis-Emitter-Strecke des Transistors V2 zum Anschluß A2 bewirkt werden würde.

Bei einer anderen Ausführungsform der Erfindung ist der Transistor V2 durch einen MOS-Transistor realisiert. Der Transistor V1 kann wegen der bei MOS-Transistoren vorgesehenen Inversdiode nicht durch einen solchen Transistortyp ersetzt werden.

### Bezugszeichenliste

- U1, U2: Spannungsquelle
- IC1, IC2: integrierte Schaltung
- A1, A2: Anschluß
- SP: Schaltung zur Pegelumsetzung
- GND: Bezugspotential
- V1, V2: Transistor
- R1 bis R4: Widerstände

## Patentansprüche

1. Pegelanpassung, insbesondere für Bussysteme, welche derart ausgestaltet ist, dass eine Spannungsquelle (U1), die eine höhere Versorgungsspannung liefert, und eine Spannungsquelle (U2), die eine niedrigeren Versorgungsspannung liefert, vorgesehen sind, dass ein erster Anschluss (A1) zum Senden und Empfangen von Signalen mit einem hohen Pegel, der an der Spannungsquelle (U1) mit der höheren Versorgungsspannung abgegriffen wird, und dass ein zweiter Anschluss (A2) zum Senden und Empfangen von Signalen mit einem niedrigeren Pegel, der an der Spannungsquelle (U2) mit der niedrigeren Versorgungsspannung abgegriffen wird, vorgesehen sind, und dass ferner zwei Bipolar-Transistoren (V1,V2) vorgesehen sind, deren Kollektor-Emitter-Strecken antiparallel zwischen die beiden Anschlüsse (A1) und (A2) geschaltet sind und deren Steueranschlüsse über Widerstände mit der Spannungsquelle (U2) mit der niedrigeren Versorgungsspannung verbunden sind.

2. Schaltungsanordnung zur bidirektionalen Pegelanpassung, insbesondere für Bussysteme, welche derart ausgestaltet ist, dass eine Spannungsquelle (U1), die eine höhere Versorgungsspannung liefert, und eine Spannungsquelle (U2), die eine niedrigere Versorgungsspannung liefert, vorgesehen sind, dass ein erster Anschluss (A1) zum Senden und Empfangen von Signalen mit einem hohen Pegel, der an der Spannungsquelle (U1) mit der höheren Versorgungsspannung abgegriffen wird, und dass ein zweiter Anschluss (A2) zum Senden und Empfangen von Signalen mit einem niedrigeren Pegel, der an der Spannungsquelle (U2) mit der niedrigeren Versorgungsspannung abgegriffen wird, vorgesehen sind, dass ferner ein Bipolar-Transistor (V1) vorgesehen ist, dessen Kollektor-Emitter-Strecke zwischen die beiden Anschlüsse (A1) und (A2) geschaltet ist, wobei der Kollektor am zweiten Anschluss (A2) angeschaltet ist, dass ein MOS-Transistor zwischen die beiden Anschlüsse (A1 und A2) geschaltet ist, und dass die Steueranschlüsse der beiden Transistoren (V1 und V2) über Widerstände mit der Spannungsquelle (U2) mit der niedrigeren Versorgungsspannung verbunden sind.

## Claims

1. Level matching, in particular for bus systems, which is designed such that a voltage source (U1) which delivers a relatively high supply voltage and a voltage source (U2) which delivers a relatively low supply voltage are provided, that a first connection (A1) for sending and receiving signals having a high level which is tapped off at the voltage source (U1) with the relatively high supply voltage is provided, and that a second connection (A2) for sending and receiving signals having a relatively low level which is tapped off at the voltage source (U2) with the relatively low supply voltage is provided, and that, in addition, two bipolar transistors (V1, V2) are provided whose collector-emitter paths are connected parallel to one another in opposite directions between the two connections (A1) and (A2) and whose control connections are connected to the voltage source (U2) with the relatively low supply voltage via resistors.

2. Circuit arrangement for bidirectional level matching, in particular for bus systems, which is designed such that a voltage source (U1) which delivers a relatively high supply voltage and a voltage source (U2) which delivers a relatively low supply voltage are provided, that a first connection (A1) for sending and receiving signals having a high level which is tapped off at the voltage source (U1) with the relatively high supply voltage is provided, and that a second connection (A2) for sending and receiving signals having a relatively low level which is tapped off at the voltage source (U2) with the relatively low supply voltage is provided, that, in addition, a bipolar transistor (V1) is provided whose collector-emitter path is connected between the two connections (A1) and (A2), with the collector being connected to the second connection (A2), that an MOS transistor is connected between the two connections (A1 and A2), and that the control connections of the two transistors (V1 and V2) are connected to the voltage source (U2) with the relatively low supply voltage via resistors.

## Revendications

1. Adaptation de niveau, notamment pour systèmes de bus, qui est conçue de telle sorte que sont prévues une source de tension (U1), qui délivre une tension d'alimentation plus élevée, et une source de tension (U2), qui délivre une tension d'alimentation plus faible, que sont prévus un premier raccordement (A1) destiné à émettre et à recevoir des signaux ayant un niveau élevé, lequel est prélevé sur la source de tension (U1), qui a la tension d'alimentation la plus élevée, et un deuxième raccordement (A2) destiné à émettre et à recevoir des signaux ayant un niveau plus faible, lequel est prélevé sur la source de tension (U2), qui a la tension d'alimentation la plus faible, et que sont prévus, en outre, deux transistors bipolaires (V1, V2) dont les lignes collecteur-émetteur sont montées en antiparallèle entre les raccordements (A1) et (A2) et dont les bornes de commande sont reliées, à travers des résistances, à la source de tension (U2), qui a la tension d'alimentation la plus faible.

2. Circuit destiné à l'adaptation bidirectionnelle du niveau, notamment pour systèmes de bus, qui est conçu de telle sorte que sont prévues une source de tension (U1), qui délivre une tension d'alimentation plus élevée, et une source de tension (U2), qui délivre une tension d'alimentation plus faible, que sont prévus un premier raccordement (A1) destiné à émettre et à recevoir des signaux ayant un niveau élevé, lequel est prélevé sur la source de tension (U1), qui a la tension d'alimentation la plus élevée, et un deuxième raccordement (A2) destiné à émettre et à recevoir des signaux ayant un niveau plus faible, lequel est prélevé sur la source de tension (U2), qui a la tension d'alimentation la plus faible, qu'il est prévu, en outre, un transistor bipolaire (V1) dont la ligne collecteur-émetteur est montée entre les deux raccordements (A1) et (A2), le collecteur étant raccordé au deuxième raccordement (A2), qu'un transistor MOS est monté entre les deux raccordements (A1 et A2) et que les bornes de commande des deux transistors (V1 et V2) sont reliées, à travers des résistances, à la source de tension (U2), qui a la tension d'alimentation la plus faible.
